# EUROPÄISCHE PATENTSCHRIFT

(11) **EP 4 141 459 B1**
(45) Veröffentlichungstag und Bekanntmachung des Hinweises auf die Patenterteilung: **18.06.2025**
(21) Anmeldenummer: 22190546.6
(22) Anmeldetag: 16.08.2022
(51) Int. Cl.: G01R 31/3185

(54) **INSTRUMENT ZUR AUTARKEN AUSFÜHRUNG VON PRÜFSEQUENZEN NACH JTAG-STANDARD**
INSTRUMENT FOR AUTONOMOUS EXECUTION OF TEST SEQUENCES ACCORDING TO JTAG STANDARD
INSTRUMENT D'EXÉCUTION AUTONOME DE SÉQUENCES D'ESSAI SELON LA NORME JTAG

(30) Priorität: 27.08.2021 DE 102021122253
(43) Veröffentlichungstag der Anmeldung: 01.03.2023
(73) Patentinhaber: Göpel electronic GmbH, 07745 Jena (DE)
(72) Erfinder: Werner, David, 99423 Weimar (DE); Ernst, Kevin, 07958 Hohenleuben (DE); Fuchs, Marc, 07546 Gera (DE)
(74) Vertreter: Gleim Petri Patent- und Rechtsanwaltspartnerschaft mbB

(56) Entgegenhaltungen:
- US-A1- 2010 180 169
- US-B1- 6 353 905
- US-B2- 7 047 462
- US-B2- 8 667 346

## Beschreibung

Die Erfindung betrifft eine Einrichtung zur autarken Bereitstellung von Prüfsequenzen für eine JTAG-Schnittstelle von vorgegebenen unterschiedlichen Prüfobjekten.

Das Anwendungsgebiet der Erfindung liegt auf dem Gebiet der elektronischen Endkontrolle von technischen Produkten aller Art, insbesondere in der Automobilindustrie von Einzelkomponenten, die eine elektronische Steuerung aufweisen.

Aus dem Stand der Technik sind unter dem Amerikanismus ''Boundary Scan" Testverfahren bekannt, die auf Basis eines durch die Joint Test Action Group (JTAG) eingeführten IEEE-Standards (IEEE 1149.x) Prüfsequenzen generieren. Dabei werden die Prüfsequenzen als ein sog. Prüfmuster über eine standardisierte Schnittstelle (Test Access Port) auf den Prüfling (Prüfobjekt) übertragen. Der im Standard beschriebene Hardware-Zugriff wird nicht mehr nur für den klassischen Boundary-Scan-Verbindungstest verwendet, sondern auch für die Programmierung von Speicherbausteinen, die Emulation von Protokollen oder auch zur Kombination mit anderen Testverfahren. Damit einher geht auch eine ständige Weiterentwicklung der verfügbaren Systeme zur Steuerung der JTAG-Schnittstelle. Die notwendige Software und Hardware wird mit neuen Funktionen und höherer Leistungsfähigkeit ausgestattet.

Der Grundaufbau eines solchen Testsystems bleibt jedoch stets gleich. Eine Prüf-Software muss auf einem Prüfrechner (Computer, PC) installiert werden, um die Testprojekte zu verwalten und die entsprechenden Prüfmuster zu erzeugen. Ein Hardware-Gerät, in der Regel als Steuereinheit (engl. ''Controller") bezeichnet, wird an den Prüfrechner angeschlossen (über USB, PCI, PXI o.ä.) und stellt die physikalische Verbindung zur JTAG-Schnittstelle des Prüflings her.

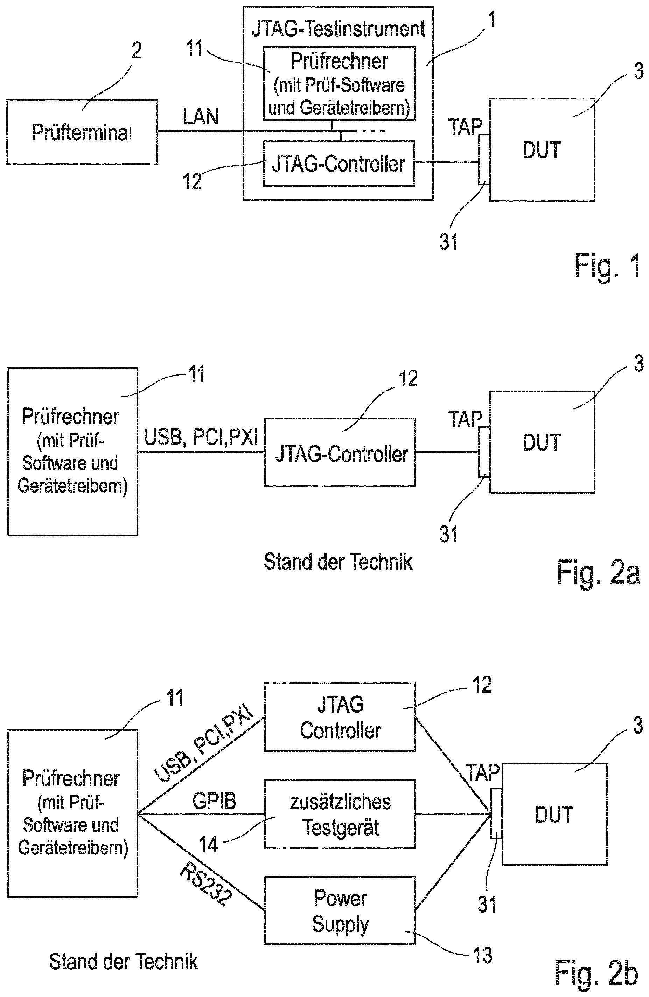

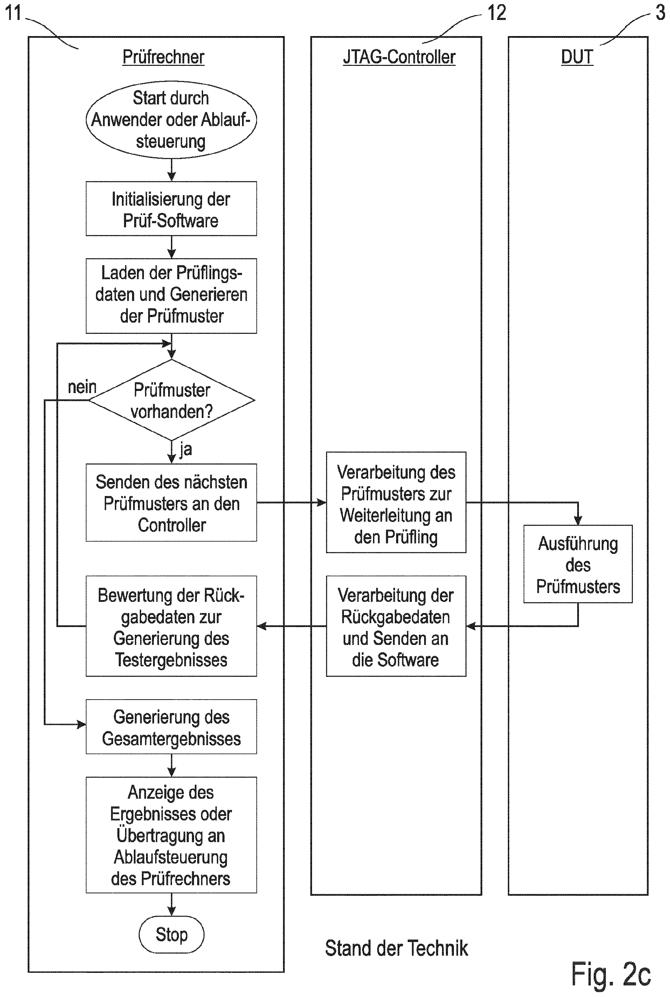

In Fig. 2a ist dieser Aufbau in vereinfachter Form gezeigt, wobei die Bezeichnung ''DUT" (Device Under Test) für einen oder mehrere Prüflinge steht. Die wesentlichen Funktionen der Verarbeitung erfolgen dabei - wie aus Fig. 2c ersichtlich - innerhalb eines Prüfrechners, in dem sämtliche Daten des Prüflings sowie dessen Prüfplan hinterlegt sind bzw. generiert werden. Jedes Prüfmuster wird im Prüfrechner erzeugt und einzeln über die jeweilige Hardware-Verbindung an den JTAG-Controller gesendet. Die Rückgabedaten vom Prüfling (DUT - Device Under Test) werden als Rohdaten vom Prüfrechner empfangen und bewertet

Die in Fig. 2c gezeigte Trennung der einzelnen Komponenten ermöglicht eine hohe Flexibilität bei der Konfiguration eines Testsystems. Der Nachteil ist jedoch, dass immer ein Prüfrechner benötigt wird, der entsprechend eingerichtet werden muss. Da ein vollumfängliches Prüfkonzept für komplexe elektronische Baugruppen in der Regel verschiedene Test- und Messverfahren enthält, werden zusätzliche Geräte und damit auch weitere Programme und Treiber im Prüfrechner benötigt.

Die möglichen zusätzlichen Geräte und Schnittstellen sind in Fig. 2b nur beispielhaft erwähnt. Der Prüfrechner als zentrales Element des Testsystems wird demnach mit verschiedenen Programmen belastet, die eine gewisse Leistungsfähigkeit voraussetzen und einzeln eingerichtet werden müssen. Wird ein Prüfrechner ausgetauscht oder soll ein Testsystem dupliziert werden, erfolgt dieselbe Inbetriebnahme erneut. Dabei entstehen Aufwände und Fehlerpotenziale bei der Synchronisierung mehrerer Stationen und es wird ein leistungsstarker Prüfrechner vorausgesetzt.

Systeme der vorstehend beschriebenen Art finden sich in unterschiedlichen Varianten im Stand der Technik.

So beschreibt die US 6 766 486 B2 einen JTAG-Tester, der zur parallelen Prüfung von integrierten Schaltkreisen vorgesehen ist. Der JTAG-Tester umfasst einen JTAG-Controller, der an einem PCI-Steckplatz eines PC angeschlossen ist, einen nichtkonventionellen 1-zu-N-Portmultiplexer, eine programmierbare Stromversorgung und eine Steuer- und Vergleichslogik, die Versorgungsspannung überwacht. Damit können, weil der Multiplexer ein 1-zu-N-Multiplexer ist, auch beliebig ausgewählte Kombinationen von Sockeln getestet werden, d.h. es können dieselben Daten in beliebig ausgewählte Geräte geschickt werden und die ausgelesenen Daten zur Auswertung laufen über den einzelnen Port zurück.

Eine weitere Lösung für eine JTAG-Testausrüstung ist in der WO 2004/046741 A1 offenbart, bei der eine asynchrone Übertragung der Testdaten zwischen den Testzugriff-Ports (Test Access Port-TAP) des Prüfobjekts (Device Under Test - DUT) und der JTAG-Testausrüstung genutzt wird. Dazu erfolgt in der Testausrüstung vor den TAPs durch ein Computerprogramm die Anpassung einer Testdatensequenz, die in einem vom TAP vorgegebenen Format ankommt, für die Übertragung auf einem asynchronen Übertagungspfad und ein Transceiver übernimmt die Anpassung der Testdatensequenz und deren Übermittlung über die asynchrone Datenübertragungsverbindung.

Ferner ist aus der US 7 047 462 B2 ein Fernbedienungsserver-Management mit einer Netzwerksteuerung mittels eines ''Remote Server Management Controller" bekannt. Hierbei handelt es sich um eine allgemeine Netzwerkstruktur mit einem Server-PC und mehreren Client-PCs. Eine Erweiterung in Form eines in sich geschlossenen Systems ist nicht vorgesehen, wodurch ein flexibler, modularer Systemaufbau nicht möglich ist. Der Erfindung liegt die Aufgabe zugrunde, eine neue Möglichkeit zur Ausführung von Prüfsequenzen gemäß dem IEEE-Standard 1149.x zu finden, die ohne zusätzliche Anpassungen an die Infrastruktur auskommt und unabhängig ist von etwaigen Anwendervoraussetzungen von unterschiedlichen Computerbetriebssystemen und Softwareschnittstellen der Prüflinge (Prüfobjekte).

Die Erfindung ist im beigefügten Anspruchssatz beschrieben.

Erfindungsgemäß wird die Aufgabe bei einer Einrichtung zur autarken Bereitstellung von Prüfsequenzen für eine JTAG-Schnittstelle von vorgegebenen unterschiedlichen Prüfobjekten, enthaltend einen Prüfrechner, in dem Prüfpläne und alle Daten von zu testenden Prüfobjekten enthalten sind, einen JTAG-Controller zur Übertragung der spezifischen Prüfsequenzen eines aktuellen Prüfobjekts zur JTAG-Schnittstelle, dadurch gelöst, dass der Prüfrechner als eingebetteter Computer in einem kompakten Testinstrument enthalten ist, wobei der Prüfrechner ein Betriebssystem und Basissoftware zur autarken Konfiguration und Inbetriebnahme des Testinstruments sowie eine Webdienst-Schnittstelle aufweist, dass das Testinstrument eine Netzwerkverbindung zur Übertragung dedizierter Steuerkommandos aufweist, um mindestens eine Verbindung mit einem externen Prüfterminal als Bedienoberfläche und zwischen dem JTAG-Controller und dem eingebetteten Prüfrechner auszubilden, und dass der eingebettete Prüfrechner ein eigenes Dienstprogramm aufweist, das ausgebildet ist, um auf http-Befehle zu reagieren, eine Prüfsoftware zur Umsetzung der Prüfpläne der Prüfobjekte zu steuern und Informationen im Webdesign zu erzeugen.

Vorteilhaft ist das Dienstprogramm des eingebetteten Prüfrechners dazu eingerichtet, automatisch zu starten und Informationen wie auf einer herkömmlichen Internetseite zu erzeugen.

Die Software des eingebetteten Prüfrechners ist bevorzugt so eingerichtet, dass der JTAG-Controller über ein Webservice-Dienstprogramm direkt steuerbar ist.

Zweckmäßig ist das Testinstrument über die Netzwerkverbindung einfach mit weiteren JTAG-Controllern verbindbar. Dabei sind die weiteren JTAG-Controller ebenfalls mit dem eingebetteten Prüfrechner des kompakten Testinstruments steuerbar.

Die Netzwerkverbindung ist vorteilhaft als Datenbus in einem geschlossenen lokalen Netzwerk (LAN) vorhanden oder kann alternativ als Datenbus in ein öffentliches Netzwerk (Internet) eingebunden sein.

Zweckmäßig ist der Prüfterminal als schlanker PC geringer Leistung ohne komplexe Berechnungsfunktionen ausgebildet. Dabei ist der Prüfterminal vorzugsweise lediglich zum Starten des Prüfplans eines Prüfobjekts und zum Empfangen und Verwalten des Prüfergebnisses nach Abschluss aller Testschritte des Prüfplans eingerichtet.

Es erweist sich für die Einrichtung eines multivalenten Prüfplatzes als besonders vorteilhaft, wenn das kompakte Testinstrument in einem Gehäuse im industrietauglichen 19"-Format mit einem Formfaktor von nur einer Höheneinheit untergebracht ist.

Des Weiteren wird die Aufgabe mit einem Verfahren zur autarken Bereitstellung von Prüfsequenzen für eine JTAG-Schnittstelle eines Prüfobjekts gelöst durch die folgenden Schritte:
- Bereitstellen eines Prüfrechners, in dem Prüfpläne und alle Daten von zu testenden Prüfobjekten hinterlegt sind oder erzeugt werden und der über ein eigenes Betriebssystem, Basissoftware und eine Webservice-Schnittstelle verfügt,
- Bereitstellen eines JTAG-Controllers zur Übertragung von spezifischen Prüfsequenzen eines aktuellen Prüfobjekts zu dessen JTAG-Schnittstelle,
- Einbetten des Prüfrechners in ein kompaktes Testinstrument mit dem JTAG-Controller, wobei vom Prüfrechner aus mittels des eigenen Betriebssystems und Basissoftware das Testinstrument autark konfiguriert und in Betrieb genommen wird,
- Verbinden des Testinstruments mit einem externen Prüfterminal als Bedienoberfläche und des eingebetteten Prüfrechners mit dem JTAG-Controller mittels einer Netzwerkverbindung zur Übertragung dedizierter Steuerkommandos,
- Starten des konfigurierten Testinstruments durch den Prüfrechner vom Prüfterminal aus über die Netzwerkverbindung,
- Steuern einer Prüfsoftware zur Umsetzung eines Prüfplans eines aktuell zu testenden Prüfobjekts durch den Prüfrechner mittels eines eigenen Dienstprogramms, das als Webservice auf http-Befehle reagiert und das über die Netzwerkverbindung mit dem JTAG-Controller kommuniziert, um die Prüfsequenzen an der JTAG-Schnittstelle eines Prüfobjekts bereitzustellen,
- Anzeigen von Statusinformationen und Prüfergebnissen am Prüfterminal in einem Webdesign.

Die Erfindung basiert auf der Grundüberlegung, dass ein JTAG-Prüfcontroller und der leistungsfähige PC zur Anpassung an beliebige kundenspezifische Prüflinge und Prüfanforderungen vor allem an die Computer- und Softwarevoraussetzungen des Kunden, der den Test- bzw. Prüfplatz in Auftrag gibt, angepasst werden müssen. Dadurch entstehen erhebliche Mehraufwände an Softwareanpassungen, selbst wenn dieselbe Prüfaufgabe bei einem anderen Kunden ''dupliziert" installiert werden soll, da das Hardware-Gerät (Controller) über unterschiedliche Schnittstellensysteme (USB, LAN, PCI, PXI o.ä.) eine physikalische Verbindung zur JTAG-Schnittstelle des Prüflings herstellt. Zusätzlich ist das Computerbetriebssystem des Kunden zu berücksichtigen, das völlig unterschiedliche Programmtools, Treiber- und Lizenzerfordernisse haben kann.

Die Erfindung hat sich deshalb das Ziel gesetzt, diese Anpassungserfordernisse zu minimieren bzw. auf einen einheitlichen Stand zu bringen, sodass durch nur ein einheitliches Testinstrument, ein sog. JTAG-Instrument mit eingebettetem PC, der Prüfprozess an jedem beliebigen Prüfplatz gesteuert werden kann, während der Prüfrechner beim Kunden nur noch die Vorgabe zum Starten bestimmter Prüfsequenzen (Prüfmuster) und die Ergebnisverwaltung/-ausgabe bewerkstelligen muss. Dabei erfolgt die Kommunikation zwischen Testinstrument und Prüfrechner und ggf. anderen Geräten über eine LAN-Schnittstelle nach http-Standard, wofür der Prüfrechner ein bestimmtes Dienstprogramm bereithält, und es können geschlossene oder öffentliche Netzwerke (Internet) genutzt werden. Das Testinstrument kann dadurch auch noch mit verschiedenen weiteren JTAG-Controllern, wenn diese über eine entsprechende Webservice-Schnittstelle verfügen, ohne weitere Softwareanpassungen verbunden werden und kann - soweit zulässig - über das Internet aktualisiert, programmiert und gewartet werden.

Durch die Erfindung wird eine neue Möglichkeit zur Ausführung von Prüfsequenzen gemäß dem IEEE-Standard realisiert, die ohne zusätzliche Anpassungen an vorhandene Infrastruktur auskommt und unabhängig ist von etwaigen Kundenvoraussetzungen bezüglich Computerbetriebssystemen und Softwareschnittstellen der Prüfobjekte. Außerdem ist eine Gestaltung als Einsatzbaustein in ein typisches 19"-Rack möglich, wodurch weitere Geräte, insbesondere JTAG-Controller, in beliebiger Anzahl mit dem Testinstrument problemlos gekoppelt werden können, um parallel oder abwechselnd Prüfobjekte gleicher oder unterschiedlicher Art zu prüfen.

Die Erfindung wird nachfolgend anhand von Ausführungsbeispielen und Abbildungen näher erläutert. Dabei zeigen:
- Fig. 1:: eine schematische Darstellung der erfindungsgemäßen Einrichtung, die ein JTAG-Testgerät enthält, das autark und unabhängig von Umgebungssoftware und Betriebssystem eines Kunden einsetzbar ist,
- Fig. 2a:: eine schematische Darstellung des Standes der Technik, bei dem ein Prüfrechner mit anspruchsvoller Prüfsoftware für die Testprojektverwaltung und Prüfmustererzeugung ausgestattet und mit einem Controller über kundenspezifische Schnittstellen (z.B. USB, PCI, PXI) verbunden ist und die physikalische Verbindung zur JTAG-Schnittstelle des Prüfobjekts herstellt,
- Fig. 2b:: eine schematische Darstellung einer erweiterten Ausführung des Standes der Technik mit gegenüber Fig. 2a hinzugefügten weiteren Geräten und Schnittstellen, deren Software jeweils an die spezielle Softwareumgebung anzupassen sind;
- Fig. 2c:: ein zugehöriges Ablaufschema des Prüfaufbaus gemäß Fig. 2a, bei dem der Prüfrechner sämtliche Daten des Prüfobjekts, dessen Prüfplan hinterlegt sind bzw. generiert,
- Fig. 3:: eine schematische Darstellung des Ablaufschemas der erfindungsgemäßen Einrichtung, bei der das JTAG-Instrument alle Daten und Prüfprogramme von unterschiedlichen Prüfobjekten verwaltet und verarbeitet, das von außen nur über LAN-typische Befehle gesteuert wird,
- Fig. 4:: eine schematische Darstellung einer besonders vorteilhaften Gestaltung des JTAG-Testinstruments in einem an einem Prüfplatz häufig vorhandenen 19"-Rack für Elektronikkomponenten,
- Fig. 5:: eine schematische Darstellung einer erweiterten Ausführung der Erfindung mit angeschlossenen Komponenten in einem beliebigen geschlossenen oder öffentlichen Netzwerk.

Die erfindungsgemäße Einrichtung enthält in einer Grundstruktur gemäß Fig. 1 ein JTAG-Testinstrument 1, das einen eingebetteten Prüfrechner 11 und einen herkömmlich bekannten JTAG-Controller 12 beinhaltet, wobei der JTAG-Controller 12 wie üblich die Prüfabläufe der Prüfsoftware in Prüfsequenzen (sog. Prüfmuster) "übersetzt" an die Testschnittstelle 31 (TAP) des Prüfobjekts 3 weiterleitet.

Das Testinstrument 1 ist durch den zusätzlich eingebetteten Prüfrechner 11 neben der jeweiligen Prüfsoftware und Gerätetreibern der vorgegebenen Prüfobjekte 3 außerdem mit einem eigenen Betriebssystem, Basissoftware und einer Webservice-Schnittstelle ausgestattet.

Die Verarbeitung der Steuerbefehle im Testinstrument 1 erfolgt über ein spezielles internes Dienstprogramm, das auch Webservice genannt wird und eine Software ist, die als automatisch gestarteter Dienst vom eingebetteten Prüfrechner 11 bereitgestellt wird, auf http-Aufrufe reagiert und neben dedizierten Kommandos zur Steuerung der Prüf-Software auch eine Web-Ansicht mit Status-Informationen und ausführlicher Dokumentation enthält. Die Web-Ansicht ist von besonderer Bedeutung, da das Testinstrument 1 selbst weder über Bildschirm noch Maus oder Tastatur verfügt.

Mit dem Einschalten des Testinstruments 1 wird das Dienstprogramm automatisch gestartet, sodass anschließend die Web-Ansicht wie bei einer herkömmlichen Internetseite aufgerufen werden kann. Zusätzliche Handbücher und Dokumentationen sind nicht notwendig.

Um eine entsprechende Steuerung des Testinstruments 1 vornehmen zu können, ist ein relativ leistungsschwacher PC als Prüfterminal 2 vorzusehen, der in der Regel vor Ort am Prüfplatz vorhanden sein sollte und über eine Netzwerkverbindung 15 (z.B. LAN) verfügt. Mit Hilfe des Webservice kann der Prüfterminal 2 sowohl den Testablauf starten als auch Testergebnisse entgegennehmen und anzeigen, speichern oder verwalten. Außerdem ist der Prüfterminal 2 für die Hinzufügung weiterer oder neuer Prüfsoftware oder Daten von weiteren Prüfobjekten 3 geeignet, soweit diese aus anderen Quellen zur Verfügung stehen.

Das JTAG-Testinstrument 1 bildet eine Grundeinheit, die im eingebetteten Prüfrechner 11 ein eigenständiges Betriebssystem sowie notwendige Software und Lizenzen und eine vollständige Konfiguration zur Inbetriebnahme für die in sich geschlossene Einheit des Testinstruments 1 mitbringt und in einen beliebigen Prüfplatz für Prüfobjekte 3 (DUTs) bei einem Anwender integriert bzw. installiert wird. Alle Daten und Prüfprogramme der zu testenden Prüfobjekte 3 können vorab installiert werden oder erst bei Bedarf am Prüfplatz auf das Testinstrument 1 übertragen werden.

Das Testinstrument 1 wird über eine Netzwerkverbindung 15 (z.B. LAN oder Internet) mit einem externen Computer als Prüfterminal 2 verbunden. Die Netzwerkverbindung 15 sichert die Bedienung des Testinstruments 1 (das selbst keine Bedienschnittstelle, Bildschirm, Tastatur, Maus besitzt), bietet den nötigen Datendurchsatz und erfordert keine zusätzliche Treiberinstallation auf dem als Prüfterminal 2 verwendeten externen Computer (PC, Tablet, Smartphone etc.).

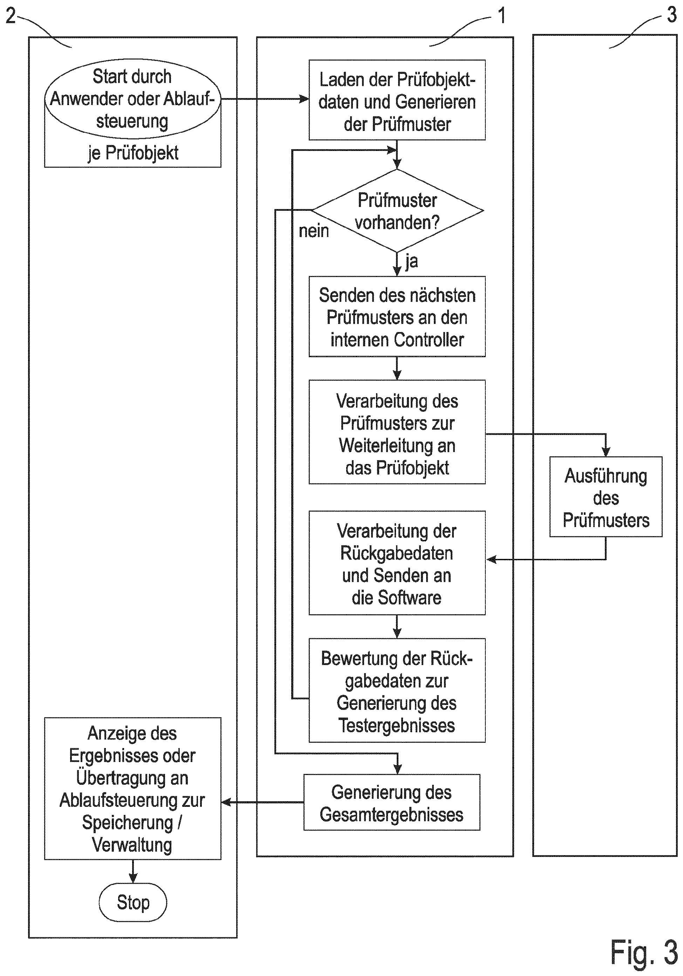

Obwohl die stilisierte Darstellung der Einrichtung gemäß Fig. 1, die einen Prüfplatz für sog. DUTs (Prüfobjekte 3) darstellt, sehr ähnlich zu der Darstellung von Fig. 2a gemäß dem Stand der Technik aussieht, ist der gravierende Unterschied sehr deutlich aus dem Vergleich des Prüfablaufes gemäß Fig. 3 in Gegenüberstellung zur Darstellung von Fig. 2c (Stand der Technik) zu erkennen.

Der beim Anwender vorgehaltene Computer ist bei der Einrichtung gemäß der vorliegenden Erfindung der Prüfterminal 2, der lediglich für die Auslöse-(Start-) und Anzeigefunktion einer Prüfprozedur bei einem oder mehreren Prüfobjekten 3 sowie die Ergebnisverwaltung zuständig ist. Der Prüfterminal 2 gibt nur das Startsignal und erhält nach Abschluss aller Testschritte ein Gesamtergebnis. Er kann in diesem Fall ein sehr leistungsschwacher PC sein, der lediglich die Aufrufe der gewünschten Testschritte realisiert und die Ergebnisse entgegennimmt und diese Funktion über die Netzwerkverbindung 15 und den oben erwähnten Webservice ausführt.

Im Gegensatz dazu muss der gemäß Fig. 2b (Stand der Technik) beim Anwender vorgehaltene Computer ein sehr leistungsfähiger PC sein, auf dem die Prüfabläufe der Prüfsoftware, die Gerätedaten der Prüfobjekte 3, Lizenzen für Gerätetreiber, die Erzeugung der Prüfmuster für weitere Geräte 14 sowie gegebenenfalls die Steuerung einer Stromversorgung 13 unter den jeweiligen Gegebenheiten der Umgebungssoftware und des Betriebssystems beim Anwender jeweils gesondert installiert werden müssen.

Bei der erfindungsgemäßen Einrichtung ist für die eigentliche Bearbeitung und Verarbeitung, d h. Auswahl und Durchführung des Prüfungsablaufs laut Prüfplan und Berücksichtigung der Gerätedaten des Prüfobjekts 3, das Testinstrument 1 und insbesondere der eingebettete Prüfrechner 11 zuständig. Der JTAG-Controller 12 wird dabei in Analogie zum Stand der Technik für die Umsetzung des Prüfplans in TAPkompatible Prüfmuster des Prüfobjekts 3 verwendet und sorgt für die Übertragung an die Testschnittstelle 31 (TAP).

Der Programmablauf wird im Testinstrument 1 vom Prüfrechner 11 mittels einer für das jeweilige Prüfobjekt 3 entwickelten Prüfsoftware mit folgenden Schritten durchgeführt:
- Laden der Prüfobjektdaten eines zu prüfenden Prüfobjekts 3 und Generieren mindestens eines Prüfmusters (Prüfsequenz),
- Auswahl eines Prüfmusters und Senden an den (internen) JTAG-Controller 12,
- Verarbeiten des Prüfmusters im JTAG-Controller 12 zur Übertragung an das Prüfobjekt 3,
- Ausführen des Prüfmusters im Prüfobjekt 3,
- Verarbeiten der vom Prüfobjekt 3 kommenden Rückgabedaten im Prüfrechner 11 des Testinstruments 1 mittels der zugehörigen Prüfsoftware des Prüfobjekts 3,
- Bewertung der Rückgabedaten zur Erzeugung eines Testergebnisses,
- Wiederholung der Prüfung mit einem weiteren Prüfmuster, soweit vorhanden,
- Erzeugung eines Gesamtergebnisses der Prüfung des Prüfobjekts 3 im Testinstrument 1, und
- Anzeige der Prüfergebnisse am Prüfterminal 2 oder Übertragung an eine Ablaufsteuerung zur Festlegung von Testabläufen und zur Verwaltung der Ergebnisse.

Die Ablaufsteuerung (häufig auch Sequencer genannt) kann als eine relativ beliebige Software vorhanden sein oder diese beinhalten. Sie stellt eher ein Verwaltungsprogramm als eine anspruchsvolle Steuersoftware dar.

In einem Testsystem eines Prüfplatzes des Anwenders wird normalerweise nur ein Testinstrument 1 benötigt und einzelne JTAG-Controller 12 können nach Bedarf einfach ergänzt werden, wenn andere Prüfobjekte 3 oder andere Prüfmuster parallel oder abwechselnd getestet werden sollen.

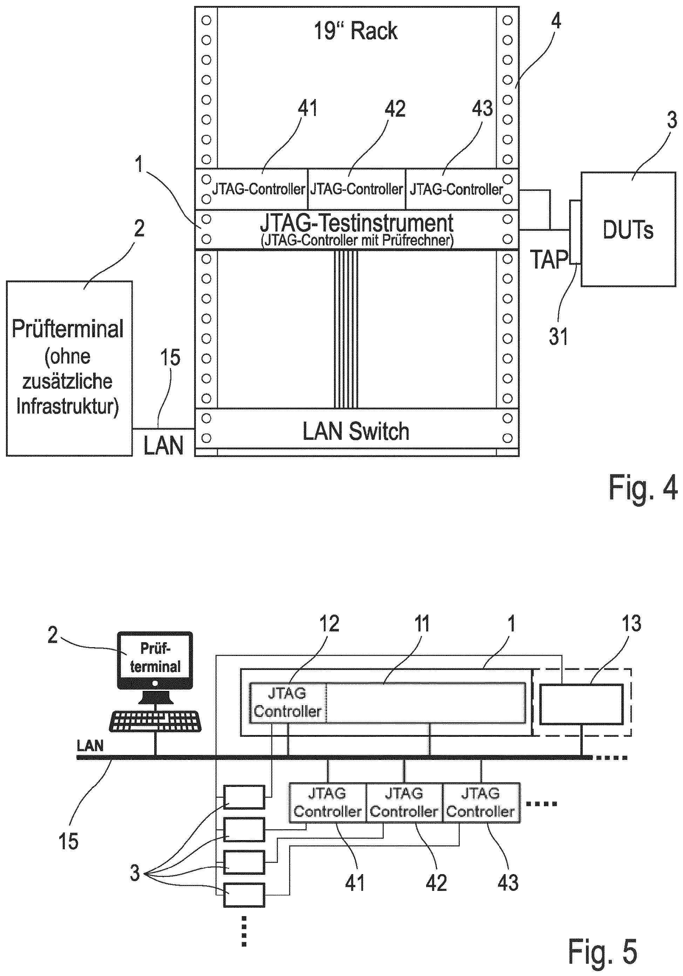

Mit einer einzigen Netzwerkverbindung 15 können vom Prüfterminal 2 aus auch verschiedene Testinstrumente 1 und ggf. auch nur ein Testinstrument 1 und weitere JTAG-Controller 41, 42, 43, ... (nur in Fig. 4 und 5 bezeichnet) gleichermaßen gesteuert bzw. aufgerufen werden.

Fig. 4 zeigt eine bevorzugte Variante für die Ausgestaltung eines Prüfplatzes beim Anwender der erfindungsgemäßen Einrichtung mit dem Testinstrument 1 als 19"-Einschub für ein in der Industrie häufig anzutreffendes 19"-Rack als tragendes Gehäuse 4. Dabei ist das Testinstrument 1 durch weitere JTAG-Controller 41, 42, 43 ergänzt, die mit demselben Testinstrument 1 angesteuert und ausgewertet werden können. Es sind aber auch mehrere Testinstrumente 1 in das 19"-Gehäuse 4 einsetzbar. In jedem Fall erfolgt die Kommunikation über eine gemeinsame Netzwerkverbindung 15 (Netzwerkbus), die über den oben erwähnten Webservice betrieben wird und eine Verwaltung des gesamten Prüfplatzes vom Prüfterminal 2 ermöglicht.

Fig. 5 zeigt eine beispielhafte Gestaltung der Organisation des Testinstruments 1 an einem Prüfplatz für mehrere Prüfobjekte 3 über eine Netzwerkverbindung 15, die entweder ein geschlossenes lokales Netzwerk (LAN, Intranet) oder auch ein öffentliches Netzwerk (Internet) sein kann.

Dabei hat die Nutzung des Internet den Vorteil, dass die Programmierung, Installation und Wartung vom Hersteller/Betreiber des Testinstruments 1 als Fernbetreuung geleistet werden könnten. Der Vorzug des geschlossenen lokalen Netzwerks (LAN) als Netzwerkverbindung 15 liegt in der Absicherung vor unbefugtem oder missbräuchlichem Zugriff oder Störung des Prüfbetriebs von außen.

Der Vorteil der Konfiguration gemäß Fig. 5 liegt vor allem darin, dass der dargestellte Prüfplatz bei einem Anwender sowohl die parallele Testung von gleichen Prüfobjekten 3 als auch eine Erweiterung eines ursprünglich eingerichteten Prüfplatzes für weitere, möglicherweise andersartige Prüfobjekte 3 gestattet, die abwechselnd am Prüfplatz zu testen sind. Dabei können die weiteren JTAG-Controller 41, 42, 43 auf Prüfmuster für möglicherweise völlig unterschiedliche Testschnittstellen 31 (TAP) von Prüfobjekten 3 zugeschnitten sein, werden aber vom selben eingebetteten Prüfrechner 11 bezüglich der Prüfsoftware und Prüfpläne gesteuert. Dadurch ist das System einfach durch Hinzufügen weiterer JTAG-Controller 41, 42, 43, ... erweiterbar, solange der Prüfrechner 11 im Testinstrument 1 noch Installationskapazität für weitere Prüfsoftware hat. Andernfalls kann das System durch ein weiteres Testinstrument 1 ergänzt werden (nicht gezeichnet), das ebenfalls wieder mehrere weitere JTAG-Controller 41, 42, 43... mit bedienen kann.

Des Weiteren ist in Fig. 5 die Organisation des gesamten Prüfplatzes inklusive der Einbindung einer Stromversorgung 13 dargestellt, die als eine steuerbare Stromversorgung ebenfalls an den Bus der Netzwerkverbindung 15 angeschlossen ist und somit für unterschiedliche Prüfobjekte 3 bezüglich der erforderlichen Betriebsspannungen gesteuert werden kann.

Wie die gestrichelte Linie um die Stromversorgung 13 verdeutlichen soll, kann die Stromversorgung 13 auch ein Teil des Testinstruments 1 sein, falls zur Realisierung spezieller Prüfpläne beispielsweise mehrere Prüfspannungen erforderlich sind. In diesem Fall wäre durch den Prüfrechner 11 auch eine direkte Steuerung (nicht gezeichnet) innerhalb des Testinstruments 1 möglich.

### Bezugszeichenliste

- 1: Testinstrument
- 11: Prüfrechner
- 12: JTAG-Controller
- 13: Spannungsversorgung
- 14: zusätzliches Testgerät
- 15: Netzwerkverbindung

- 2: Prüfterminal

- 3: Prüfobjekt / DUT
- 31: Testschnittstelle / TAP

- 4: Gehäuse (19"-Rack)
- 41, 42, 43: weitere JTAG-Controller

## Patentansprüche

1. Einrichtung zur autarken Bereitstellung von Prüfsequenzen für eine JTAG-Schnittstelle von vorgegebenen unterschiedlichen Prüfobjekten, enthaltend einen Prüfrechner, in dem Prüfpläne und alle Daten von zu testenden Prüfobjekten enthalten sind, einen JTAG-Controller zur Übertragung der spezifischen Prüfsequenzen eines aktuellen Prüfobjekts zur JTAG-Schnittstelle, wobei
- der Prüfrechner (11) als eingebetteter Computer in einem kompakten Testinstrument (1) enthalten ist, wobei der Prüfrechner (11) ein Betriebssystem und Basissoftware zur autarken Konfiguration und Inbetriebnahme des Testinstruments (1) sowie eine Webdienst-Schnittstelle aufweist,
- der eingebettete Prüfrechner (11) ein eigenes Dienstprogramm aufweist, das derart ausgebildet ist, um wie ein Webservice mit http-Befehlen zu agieren, Prüfsoftware zur Umsetzung der Prüfpläne der Prüfobjekte (3) zu steuern und Informationen im Webdesign zu erzeugen, und
- das Testinstrument (1) eine lokale Netzwerkverbindung (15) zur Übertragung dedizierter Steuerkommandos zwischen dem JTAG-Controller (12) und dem eingebetteten Prüfrechner (11) aufweist und eine Verbindung von einem externen Prüfterminal (2) mit der lokalen Netzwerkverbindung (15) vorhanden ist, um das externe Prüfterminal (2) als Bedienoberfläche des eingebetteten Prüfrechners (11) auszubilden.

2. Einrichtung nach Anspruch 1, **dadurch gekennzeichnet, dass** das Dienstprogramm des eingebetteten Prüfrechners (11) so eingerichtet ist, automatisch zu starten und Informationen wie auf einer herkömmlichen Internetseite zu erzeugen.

3. Einrichtung nach Anspruch 1 oder 2, **dadurch gekennzeichnet, dass** die Software des eingebetteten Prüfrechners (11) so eingerichtet ist, dass der JTAG-Controller (12) über ein Webservice-Dienstprogramm direkt steuerbar ist.

4. Einrichtung nach Anspruch 1 bis 3, **dadurch gekennzeichnet, dass** das Testinstrument (1) über die Netzwerkverbindung (15) mit weiteren JTAG-Controllern (41, 42, 43) verbindbar ist.

5. Einrichtung nach Anspruch 4, **dadurch gekennzeichnet, dass** die weiteren JTAG-Controller (12) ebenfalls mit dem eingebetteten Prüfrechner (11) des kompakten Testinstruments (1) steuerbar sind.

6. Einrichtung nach einem der Ansprüche 1 bis 5, **dadurch gekennzeichnet, dass** die Netzwerkverbindung (15) in einem geschlossenen lokalen Netzwerk (LAN) vorhanden ist.

7. Einrichtung nach einem der Ansprüche 1 bis 5, **dadurch gekennzeichnet, dass** die Netzwerkverbindung (15) in einem öffentlichen Netzwerk (Internet) vorhanden ist.

8. Einrichtung nach einem der Ansprüche 1 bis 7, **dadurch gekennzeichnet, dass** der Prüfterminal (2) als schlanker PC geringer Leistung ohne komplexe Berechnungsfunktionen ausgebildet ist.

9. Einrichtung nach Anspruch 8, **dadurch gekennzeichnet, dass** der Prüfterminal (2) lediglich zum Starten des Prüfplans eines Prüfobjekts und zum Empfangen und Verwalten des Prüfergebnisses nach Abschluss aller Testschritte des Prüfplans eingerichtet ist.

10. Einrichtung nach einem der Ansprüche 1 bis 9, **dadurch gekennzeichnet, dass** das kompakte Testinstrument (1) in einem Gehäuse (4) im industrietauglichen 19"-Format mit einem Formfaktor von nur einer Höheneinheit untergebracht ist.

11. Verfahren zur autarken Bereitstellung von Prüfsequenzen für eine JTAG-Schnittstelle eines Prüfobjekts, mit den Schritten:
- Bereitstellen eines Prüfrechners (11), in dem Prüfpläne und alle Daten von zu testenden Prüfobjekten (3) hinterlegt sind oder erzeugt werden und der über ein eigenes Betriebssystem, Basissoftware und eine Webservice-Schnittstelle verfügt,
- Bereitstellen eines JTAG-Controllers (12) zur Übertragung von spezifischen Prüfsequenzen eines aktuellen Prüfobjekts (3) zu dessen JTAG-Schnittstelle (31),
- Einbetten des Prüfrechners (11) in ein kompaktes Testinstrument (1) mit dem JTAG-Controller (12), wobei vom Prüfrechner (11) aus mittels des eigenen Betriebssystems und Basissoftware das Testinstrument (1) autark konfiguriert und in Betrieb genommen wird,
- Verbinden des eingebetteten Prüfrechners (11) mit dem JTAG-Controller (12) mittels einer lokalen Netzwerkverbindung (15) zur Übertragung dedizierter Steuerkommandos und des Testinstruments (1) mit einem externen Prüfterminal (2) als Bedienoberfläche des Prüfrechners (11) über dessen Webservice-Schnittstelle an die lokale Netzwerkverbindung (15),
- Starten des konfigurierten Testinstruments (1) durch den Prüfrechner (11) mittels Befehlseingabe vom Prüfterminal (2) aus über die lokale Netzwerkverbindung (15),
- Steuern einer Prüfsoftware zur Umsetzung eines Prüfplans eines aktuell zu testenden Prüfobjekts (3) durch den Prüfrechner mittels eines eigenen Dienstprogramms, das wie ein Webservice mit http-Befehlen agiert und das über die lokale Netzwerkverbindung (15) mit dem JTAG-Controller (12) kommuniziert, um die Prüfsequenzen an der JTAG-Schnittstelle (31) eines Prüfobjekts (3) bereitzustellen,
- Anzeigen von Statusinformationen und Prüfergebnissen am Prüfterminal (2) in einem Webdesign.

## Claims

1. A device for the autonomous provision of test sequences for a JTAG interface of predetermined different test objects, containing a test computer in which test plans and all data of test objects to be tested are contained, and a JTAG controller for transmitting the specific test sequences of a current test object to the JTAG interface,
wherein
- the test computer (11) is contained as an embedded computer in a compact test instrument (1), wherein the test computer (11) has an operating system and basic software for autonomous configuration and starting of the test instrument (1) as well as a web service interface,
- the embedded test computer (11) has its own utility program which is configured to act like a web service with http commands, to control test software for implementing the test plans of the test objects (3) and to generate information in web design, and
- the test instrument (1) has a local network connection (15) for transmitting dedicated control commands between the JTAG controller (12) and the embedded test computer (11), and there is a connection from an external test terminal (2) to the local network connection (15) in order to form the external test terminal (2) as a user interface of the embedded test computer (11).

2. The device according to claim 1, **characterized in that**
the utility program of the embedded test computer (11) is set up to start automatically and generate information as on a conventional website.

3. The device according to claim 1 or 2, **characterized in that**
the software of the embedded test computer (11) is set up so that the JTAG controller (12) can be controlled directly via a web service utility program.

4. The device according to claims 1 to 3, **characterized in that**
the test instrument (1) can be connected to other JTAG controllers (41, 42, 43) via the network connection (15).

5. The device according to claim 4, **characterized in that**
the other JTAG controllers (12) can also be controlled by the embedded test computer (11) of the compact test instrument (1).

6. The device according to any one of claims 1 to 5, **characterized in that**
the network connection (15) is present in a closed local area network (LAN).

7. The device according to any one of claims 1 to 5, **characterized in that**
the network connection (15) is present in a public network (Internet).

8. The device according to any one of claims 1 to 7, **characterized in that**
the test terminal (2) is designed as a slim, low-power PC without complex calculation functions.

9. The device according to claim 8, **characterized in that**
the test terminal (2) is only set up to start the test plan of a test object and to receive and manage the test result after all test steps of the test plan have been completed.

10. The device according to any one of claims 1 to 9, **characterized in that**
the compact test instrument (1) is housed in an industrial 19" format housing (4) with a form factor of just one height unit.

11. A method for the autonomous provision of test sequences for a JTAG interface of a test object, comprising the steps of:
- providing a test computer (11) in which test plans and all data of test objects (3) to be tested are stored or generated and which has its own operating system, basic software and a web service interface,
- providing a JTAG controller (12) for transferring specific test sequences of a current test object (3) to its JTAG interface (31),
- embedding the test computer (11) in a compact test instrument (1) with the JTAG controller (12), wherein the test instrument (1) is configured and started autonomously via the test computer (11) using its own operating system and basic software,
- connecting the embedded test computer (11) to the JTAG controller (12) via a local network connection (15) for transmitting dedicated control commands and connecting the test instrument (1) with an external test terminal (2) as a user interface of the test computer (11) via its web service interface to the local network connection (15),
- starting the configured test instrument (1) via the test computer (11) by inputting commands from the test terminal (2) via the local network connection (15),
- controlling a test software for the implementation of a test plan of a test object (3) currently to be tested by the test computer by means of its own utility program, which acts like a web service with http commands and which communicates with the JTAG controller (12) via the local network connection (15) in order to provide the test sequences at the JTAG interface (31) of a test object (3),
- displaying status information and test results on the test terminal (2) in a web design.

## Revendications

1. Dispositif pour la mise à disposition autonome de séquences d'essai pour une interface JTAG d'objets d'essai différents prédéfinis, contenant un ordinateur d'essai, dans lequel sont contenus des plans d'essai et toutes les données d'objets d'essai à tester, et un contrôleur JTAG pour la transmission des séquences d'essai spécifiques d'un objet d'essai actuel vers l'interface JTAG,
dans lequel
- l'ordinateur d'essai (11) est contenu sous forme d'ordinateur intégré dans un instrument de test compact (1), l'ordinateur d'essai (11) présentant un système d'exploitation et un logiciel de base pour la configuration et la mise en service autonomes de l'instrument de test (1) ainsi qu'une interface de service web,
- l'ordinateur d'essai intégré (11) présente son propre programme utilitaire qui est conçu de manière à agir comme un service web avec des instructions http, à commander le logiciel d'essai pour la mise en œuvre des plans d'essai des objets d'essai (3) et à générer des informations en design web, et
- l'instrument de test (1) a une connexion réseau locale (15) pour transmettre des commandes de contrôle dédiées entre le contrôleur JTAG (12) et l'ordinateur d'essai intégré (11), et une connexion d'un terminal d'essai externe (2) à la connexion réseau locale (15) est présente pour former le terminal d'essai externe (2) comme interface utilisateur de l'ordinateur d'essai intégré (11).

2. Dispositif selon la revendication 1, **caractérisé en ce que**
le programme utilitaire de l'ordinateur d'essai intégré (11) est adapté pour démarrer automatiquement et générer des informations comme sur une page Internet classique.

3. Dispositif selon la revendication 1 ou 2, **caractérisé en ce que**
le logiciel de l'ordinateur d'essai intégré (11) est agencé de telle sorte que le contrôleur JTAG (12) peut être commandé directement par l'intermédiaire d'un utilitaire de service web.

4. Dispositif selon l'une quelconque des revendications 1 à 3, **caractérisé en ce que** l'instrument de test (1) peut être connecté à d'autres contrôleurs JTAG (41, 42, 43) via la connexion réseau (15).

5. Dispositif selon la revendication 4, **caractérisé en ce que**
les autres contrôleurs JTAG (12) peuvent également être commandés par l'ordinateur d'essai intégré (11) de l'instrument de test compact (1).

6. Dispositif selon l'une quelconque des revendications 1 à 5, **caractérisé en ce que**
la connexion réseau (15) est présente dans un réseau local fermé (LAN).

7. Dispositif selon l'une quelconque des revendications 1 à 5, **caractérisé en ce que**
la connexion réseau (15) est présente dans un réseau public (Internet).

8. Dispositif selon l'une quelconque des revendications 1 à 7, **caractérisé en ce que**
le terminal d'essai (2) est conçu comme un PC mince de faible puissance sans fonctions de calcul complexes.

9. Dispositif selon la revendication 8, **caractérisé en ce que**
le terminal d'essai (2) est agencé uniquement pour démarrer le plan d'essai d'un objet d'essai et pour recevoir et gérer le résultat d'essai après avoir terminé toutes les étapes d'essai du plan d'essai.

10. Dispositif selon l'une quelconque des revendications 1 à 9, **caractérisé en ce que** l'instrument de test compact (1) est logé dans un boîtier (4) au format 19" adapté à l'industrie avec un facteur de forme d'une unité de hauteur seulement.

11. Procédé pour la mise à disposition autonome de séquences d'essai pour une interface JTAG d'un objet d'essai, comprenant les étapes suivantes :
- mise à disposition d'un ordinateur d'essai (11) dans lequel sont déposés ou générés des plans d'essai et toutes les données d'objets d'essai (3) à tester et qui dispose de son propre système d'exploitation, d'un logiciel de base et d'une interface de service web,
- mise à disposition d'un contrôleur JTAG (12) pour transmettre des séquences d'essai spécifiques d'un objet d'essai courant (3) à son interface JTAG (31),
- intégration de l'ordinateur d'essai (11) dans un instrument de test compact (1) avec le contrôleur JTAG (12), l'instrument de test (1) étant configuré et mis en service de manière autonome à partir de l'ordinateur d'essai (11) au moyen du propre système d'exploitation et du logiciel de base,
- connexion de l'ordinateur d'essai intégré (11) au contrôleur JTAG (12) au moyen d'une connexion réseau locale (15) pour la transmission de commandes de contrôle dédiées et de l'instrument de test (1) avec un terminal d'essai externe (2) en tant qu'interface utilisateur de l'ordinateur d'essai (11) via son interface de service web à la connexion réseau locale (15),
- démarrage de l'instrument de test configuré (1) par l'ordinateur d'essai (11) au moyen d'une entrée de commande depuis le terminal d'essai (2) via la connexion réseau locale (15),
- commande d'un logiciel d'essai pour la mise en œuvre d'un plan d'essai d'un objet d'essai (3) actuellement à tester par l'ordinateur d'essai au moyen d'un programme utilitaire propre qui agit comme un service web avec des instructions http et qui communique avec le contrôleur JTAG (12) via la connexion réseau locale (15) pour fournir les séquences d'essai à l'interface JTAG (31) d'un objet d'essai (3),
- affichage des informations d'état et des résultats de contrôle sur le terminal d'essai (2) dans un design web.
